# EUROPEAN PATENT APPLICATION

(11) **EP 4 770 409 A2**
(43) Date of publication of application: **01.07.2026**
(21) Application number: 25226043.5
(22) Date of filing: 19.12.2025
(51) Int. Cl.: H10W 42/20, H10W 76/15, H10W 90/10, H10W 90/00

(54) **POWER MODULE, POWER CONVERTER, AND PHOTOVOLTAIC MODULE**

(30) Priority: 31.12.2024 CN 202411996792
(71) Applicant: Huawei Technologies Co., Ltd., Shenzhen, Guangdong 518129 (CN)
(72) Inventor: ZHANG, Chengliang, Shenzhen, 518129 (CN); LI, Xin, Shenzhen, 518129 (CN); SHI, Mingshuo, Shenzhen, 518129 (CN); WU, Baoshan, Shenzhen, 518129 (CN); DONG, Xiaowei, Shenzhen, 518129 (CN)
(74) Representative: Gill Jennings & Every LLP

(57) **Abstract**

This application provides a power module, a power converter, and a photovoltaic module. The power converter includes a circuit board and the power module. The power module includes a first metal layer, a first base, a metal shield layer, and a second base. The first base includes a first side edge and a second side edge that are opposite, and the second base includes a third side edge and a fourth side edge that are opposite. A distance between the first side edge and the second side edge is equal to a distance between the third side edge and the fourth side edge. Projection of the first side edge on the second base is located on a same straight line as the third side edge, and projection of the second side edge on the second base is located on a same straight line as the fourth side edge. The first metal layer and the first base are provided with openings, and a first pin is electrically connected to the metal shield layer via the openings. The power module uses a double-layer base structure. During welding, same tooling can be used to limit the first base and the second base in a direction perpendicular to the first side edge, to facilitate welding of the two layers of bases, thereby avoiding a safety risk caused by a welding deviation.

## Description

### TECHNICAL FIELD

This application relates to the field of photovoltaic power generation technologies, and in particular, to a power module, a power converter, and a photovoltaic module.

### BACKGROUND

Currently, photovoltaic power generation is converting, via an inverter, a direct current generated by a photovoltaic module into an alternating current that meets a requirement of a power grid, and connecting the alternating current to the public power grid. A photovoltaic system usually includes devices such as a photovoltaic module, an optimizer, and an inverter. After the optimizer is mounted on the photovoltaic module, the optimizer continuously performs maximum power point tracking (maximum power point tracking, MPPT) on each photovoltaic module to increase energy yield of the photovoltaic system, and has functions such as module-level shutdown and module-level monitoring. Because an output voltage that can be generated by a single photovoltaic module is usually low, to ensure normal operation of the photovoltaic system, a plurality of photovoltaic modules are generally connected in series to form a photovoltaic string, and the photovoltaic string is connected to the inverter.

The optimizer includes a power conversion circuit, configured to change output power of the photovoltaic string, to track maximum output power of the photovoltaic string. The power conversion circuit is disposed in the power module. To improve electromagnetic compatibility (electromagnetic compatibility, EMC) of the optimizer, the power module may be of a double-layer direct bonding copper (direct bonding copper, DBC) substrate structure, and a power component is disposed on a surface of one side of two layers of DBC substrates. A metal layer between two ceramic bases of the two layers of DBC substrates is used as a shield layer, to perform electromagnetic shielding on a magnetic field generated by the power component.

The power module further includes a plurality of pins. The plurality of pins include a shield pin connected to the shield layer. To arrange the shield pin and another pin on a same side, sizes of the two DBC substrates are set to different sizes in one direction, so that the shield layer extends along a large-sized DBC substrate and is configured to connect to the shield pin, and the another pin is disposed on a ceramic base of the large-sized DBC substrate and is connected to a metal layer of a small-sized DBC substrate via a bonding wire. However, when the two DBC substrates are welded, because the sizes of the two DBC substrates are different, it is difficult to design a tooling detent during welding, and the two DBC substrates are prone to deviate during welding. As a result, a distance between a pin and a heat sink plane of the power module after packaging deviates, and consequently, a creepage distance is shortened and a safety risk is easily caused.

### SUMMARY

This application provides a power module, a power converter, and a photovoltaic module, to facilitate welding of two layers of bases of the power module, thereby avoiding a safety risk caused by a welding deviation of the two layers of bases.

According to a first aspect, this application provides a power converter. The power converter includes a circuit board and a power module. The power module is located on one side of the circuit board. The power module includes a packaging housing, and a first metal layer, a first base, a metal shield layer, and a second base that are located in the packaging housing and that are sequentially stacked. The first base includes a first side edge and a second side edge that are oppositely disposed, and the second base includes a third side edge and a fourth side edge that are oppositely disposed. A distance between the first side edge and the second side edge is equal to a distance between the third side edge and the fourth side edge, projection of the first side edge on the second base is located on a same straight line as the third side edge, and projection of the second side edge on the second base is located on a same straight line as the fourth side edge. At least one of the first side edge and the second side edge is provided with a first opening, the first metal layer is provided with a second opening disposed in correspondence with the first opening, and the first opening communicates with the second opening. The power module further includes at least one first pin. One end of the at least one first pin is electrically connected to the metal shield layer via the second opening of the first metal layer and the first opening of the first base, and the other end of the at least one first pin penetrates the packaging housing and is connected to the circuit board.

In this application, the power module of the power converter uses a double-layer base structure, and the two layers of bases are fastened together through welding. Before welding, a surface of one side of the first base is coated with the first metal layer, a surface of the other side of the first base is coated with another metal layer, and a surface of one side of the second base is coated with a metal layer. During welding, the another metal layer of the first base and the metal layer of the second base are welded to form a welding layer, and the welding layer is used as the metal shield layer. In a direction opposite to the first side edge and the second side edge, that is, in a direction perpendicular to the first side edge and the second side edge, a length of the first base is equal to a length of the second base. Therefore, during welding, same tooling can be used to limit both the first base and the second base in the direction, to facilitate welding of the two layers of bases of the power module, thereby avoiding a safety risk caused by a welding deviation of the two layers of bases.

In the power converter, the first opening and the second opening may be notches, and the notch of the first metal layer communicates with the notch of the first base. Specifically, the one end of the at least one first pin is connected, via the notch of the first metal layer and the notch of the first base, to a surface of a side that is of the metal shield layer and that is away from the second base. The other end of at least one second pin penetrates the packaging housing and is connected to the circuit board. In this technical solution, the notches are obtained through cutting on the first base and the first metal layer, so that the one end of the first pin may be directly connected to the surface of the side that is of the metal shield layer and that is away from the second base, thereby simplifying manufacturing of the power module.

In another technical solution, the first opening and the second opening may alternatively be through holes. A welding joint is disposed in the through hole of the first base. The one end of the at least one first pin is located on a surface of a side that is of the first base and that is away from the metal shield layer, and is welded to one end of the welding joint. The metal shield layer is welded to the other end of the welding joint. In this technical solution, the holes are drilled on the first base and the first metal layer, a through-hole welding process is used, and the first pin and the metal shield layer are welded via the through hole of the first base, so that the first pin and the first metal layer can be disposed at a same layer, and a structure of the through hole does not affect a contour of the first base, thereby simplifying manufacturing of the power module.

The power module further includes at least one second pin. One end of the at least one second pin is connected to a surface of a side that is of the first metal layer and that is away from the first base, and the other end of the at least one second pin penetrates the packaging housing and is connected to the circuit board. In this technical solution, the second pin may be directly connected to the surface of the side that is of the first metal layer and that is away from the first base. In this way, a trace connection between the second pin and the first metal layer can be omitted, thereby reducing parasitic inductance, and suppressing voltage and current spikes and electromagnetic interference caused by the parasitic inductance, to improve circuit stability of the power module.

The power converter may use a buck circuit. Specifically, the power module further includes a first metal-oxide-semiconductor field-effect transistor (metal-oxide-semiconductor field-effect transistor, MOSFET), a second MOSFET, and a bypass diode. The first MOSFET, the second MOSFET, and the bypass diode are disposed on the surface of the side that is of the first metal layer and that is away from the first base, and the first MOSFET, the second MOSFET, and the bypass diode are sequentially arranged in an extension direction of the first side edge. A plurality of grooves are disposed at the first metal layer, the plurality of grooves divide the first metal layer into a plurality of line regions, and the plurality of line regions include a first line region, a second line region, and a third line region. The first MOSFET is located in the first line region, the second MOSFET is located in the second line region, and the bypass diode is located in the third line region. In the buck circuit, the first MOSFET and the second MOSFET are connected in series to form a half-bridge structure, and the bypass diode is connected in parallel to the second MOSFET. The power module further includes a conductive sheet or a bonding wire. One end of the conductive sheet or the bonding wire is connected to the first MOSFET, and the other end of the conductive sheet or the bonding wire is connected to the second MOSFET, to connect the first MOSFET and the second MOSFET in series. The second MOSFET is connected in parallel to the bypass diode via the at least one second pin and a metal trace of the circuit board. A trace layout can be optimized based on layout locations of the first MOSFET, the second MOSFET, and the bypass diode, to avoid trace crossing or winding, thereby shortening a circuit loop of the power module, and reducing interference of a trace to the circuit. A quantity of bypass diodes is not limited. When the power module includes a plurality of bypass diodes, the bypass diodes may be sequentially arranged in the direction perpendicular to the first side edge. The power converter using the buck circuit may be a photovoltaic optimizer.

An input, a driver chip, and an output are disposed on the circuit board. The at least one second pin may specifically include an input pin, a driver pin, and an output pin. One end of the input pin is connected to the surface of the side that is of the first metal layer and that is away from the first base, and the other end of the input pin penetrates the packaging housing and is connected to the input of the circuit board. One end of the driver pin is connected to the surface of the side that is of the first metal layer and that is away from the first base, and the other end of the driver pin penetrates the packaging housing and is connected to the driver chip of the circuit board. One end of the output pin is connected to the surface of the side that is of the first metal layer and that is away from the first base, and the other end of the output pin penetrates the packaging housing and is connected to the output of the circuit board. In addition, a first ground end and a second ground end are further disposed on the circuit board. The first ground end is connected to the input via two input capacitors connected in series, and the second ground end is connected to the output via two output capacitors connected in series. The at least one first pin includes two first pins. One end of one of the two first pins is electrically connected to the metal shield layer via the first opening and the second opening, and the other end of the first pin penetrates the packaging housing and is connected to a connection point between the two input capacitors. One end of the other of the two first pins is electrically connected to the metal shield layer via the first opening and the second opening, and the other end of the other first pin penetrates the packaging housing and is connected to a connection point between the two output capacitors. The power converter of this structure may be the photovoltaic optimizer, the connection point between the two input capacitors is an input shield midpoint, and a connection point between the two output capacitors is an output shield midpoint. In this way, the metal shield layer can reduce electromagnetic interference generated by a plurality of power components and the first metal layer to another module of the power converter. In this technical solution, the first pin is a non-shield pin, and includes a power pin and/or a driver pin. The second pin is a shield pin.

When there are a plurality of second pins, the second pins may be all disposed on a same side edge, to facilitate manufacturing. In a technical solution, the at least one second pin may include two second pins, and the two second pins are respectively located at two ends of the first side edge.

The power module further includes a second metal layer, and the second metal layer is disposed on a surface of a side that is of the second base and that is away from the metal shield layer. A surface of a side that is of the packaging housing and that is away from the circuit board is provided with a third opening, and the second metal layer is exposed from the third opening. The power converter further includes a heat sink. The heat sink is attached to the second metal layer to exchange heat with the second metal layer. In this technical solution, the second metal layer may be used as a heat dissipation surface of the power module, and directly transfers heat inside the power module to the heat sink, to implement heat dissipation for the power module.

The first base and the second base may alternatively be disposed as two bases of an equal size. Specifically, the first base and the second base may be square bases. The first base further includes a fifth side edge and a sixth side edge that are oppositely disposed, and the second base includes a seventh side edge and an eighth side edge that are oppositely disposed. A distance between the fifth side edge and the sixth side edge is equal to a distance between the seventh side edge and the eighth side edge, projection of the fifth side edge on the second base is located on a same straight line as the seventh side edge, and projection of the sixth side edge on the second base is located on a same straight line as the eighth side edge. In other words, the projection of the four sides of the first base on the second base all coincide with the four sides of the second base. In this way, the tooling limiting member can limit the first base and the second base in any direction, to flexibly weld the first base and the second base.

According to a second aspect, this application provides a power module. The power module includes a packaging housing, and a first metal layer, a first base, a metal shield layer, and a second base that are located in the packaging housing. The first metal layer, the first base, the metal shield layer, and the second base are sequentially stacked. The first base includes a first side edge and a second side edge that are oppositely disposed, and the second base includes a third side edge and a fourth side edge that are oppositely disposed. A distance between the first side edge and the second side edge is equal to a distance between the third side edge and the fourth side edge, projection of the first side edge on the second base is located on a same straight line as the third side edge, and projection of the second side edge on the second base is located on a same straight line as the fourth side edge. At least one of the first side edge and the second side edge is provided with a first opening, the first metal layer is provided with a second opening disposed in correspondence with the first opening, and the first opening communicates with the second opening. The power module further includes at least one first pin. One end of the at least one first pin is electrically connected to the metal shield layer via the second opening of the first metal layer and the first opening of the first base, and the other end of the at least one first pin penetrates the packaging housing.

The power module in this application uses a double-layer base structure, the first base and the second base are fastened together through welding, and the other end of the at least one first pin is configured to connect to a circuit board. Before welding, a surface of one side of the first base is coated with the first metal layer, a surface of the other side of the first base is coated with another metal layer, and a surface of one side of the second base is coated with a metal layer. During welding, the another metal layer of the first base and the metal layer of the second base are welded to form a welding layer, and the welding layer is used as the metal shield layer. In a direction opposite to the first side edge and the second side edge, that is, in a direction perpendicular to the first side edge and the second side edge, a length of the first base is equal to a length of the second base. Therefore, during welding, same tooling can be used to limit both the first base and the second base in the direction perpendicular to the first side edge, to facilitate welding of the two layers of bases of the power module, thereby avoiding a safety risk caused by a welding deviation of the two layers of bases.

In the power module, the first opening and the second opening may be notches, and the notch of the first metal layer communicates with the notch of the first base. The one end of the at least one second pin is connected, via the notch of the first metal layer and the notch of the first base, to a surface of a side that is of the metal shield layer and that faces the second base. The other end of at least one second pin extends and penetrates the packaging housing. In this technical solution, the notches are obtained through cutting on the first base and the first metal layer, so that the one end of the first pin may be directly connected to a surface of a side that is of the metal shield layer and that is away from the second base, thereby simplifying manufacturing of the power module.

In another technical solution, the first opening and the second opening may alternatively be through holes. A welding joint is disposed in the through hole of the first base. The one end of the at least one first pin is located on a surface of a side that is of the first base and that is away from the metal shield layer, and is welded to one end of the welding joint. The metal shield layer is welded to the other end of the welding joint. In this technical solution, the holes are drilled on the first base and the first metal layer, a through-hole welding process is used, and the first pin and the metal shield layer are welded via the through hole of the first base, so that the first pin and the first metal layer can be disposed at a same layer, and a structure of the through hole does not affect a contour of the first base, thereby simplifying manufacturing of the power module.

The power module further includes at least one second pin. One end of the at least one second pin is connected to a surface of a side that is of the first metal layer and that is away from the first base, and the other end of the at least one second pin penetrates the packaging housing. In this technical solution, the second pin may be directly connected to the surface of the side that is of the first metal layer and that is away from the first base. In this way, a trace connection between the second pin and the first metal layer can be omitted, thereby reducing parasitic inductance, and suppressing voltage and current spikes and electromagnetic interference caused by the parasitic inductance, to improve circuit stability of the power module.

The power module may use a buck circuit. Specifically, the power module further includes a first MOSFET, a second MOSFET, and a bypass diode. The first MOSFET, the second MOSFET, and the bypass diode are disposed on the surface of the side that is of the first metal layer and that is away from the first base, and the first MOSFET, the second MOSFET, and the bypass diode are sequentially arranged in an extension direction of the first side edge. A plurality of grooves are disposed at the first metal layer, the plurality of grooves divide the first metal layer into a plurality of line regions, and the plurality of line regions include a first line region, a second line region, and a third line region. The first MOSFET is located in the first line region, the second MOSFET is located in the second line region, and the bypass diode is located in the third line region. In the buck circuit, the first MOSFET and the second MOSFET are connected in series to form a half-bridge structure, and the bypass diode is connected in parallel to the second MOSFET. The power module further includes a conductive sheet or a bonding wire. One end of the conductive sheet or the bonding wire is connected to the first MOSFET, and the other end of the conductive sheet or the bonding wire is connected to the second MOSFET, to connect the first MOSFET and the second MOSFET in series. The at least one first pin includes a plurality of first pins. The other end of the at least one second pin penetrates the packaging housing and is configured to connect to the circuit board, and the second MOSFET is connected in parallel to the bypass diode via the at least one second pin and a metal trace of the circuit board. A trace layout can be optimized based on layout locations of the first MOSFET, the second MOSFET, and the bypass diode, to avoid trace crossing or winding, thereby shortening a circuit loop of the power module, and reducing interference of a trace to the circuit. A quantity of bypass diodes is not limited. When the power module includes a plurality of bypass diodes, the bypass diodes may be sequentially arranged in the direction perpendicular to the first side edge. The power module using the buck circuit may be a power module of a photovoltaic optimizer.

When the power module is used in a power converter, an input, a driver chip, and an output are disposed on the circuit board of the power converter. The at least one second pin of the power module may specifically include an input pin, a driver pin, and an output pin. One end of the input pin is connected to the surface of the side that is of the first metal layer and that is away from the first base, and the other end of the input pin penetrates the packaging housing and is configured to connect to the input of the circuit board. One end of the driver pin is connected to the surface of the side that is of the first metal layer and that is away from the first base, and the other end of the driver pin penetrates the packaging housing and is configured to connect to the driver chip of the circuit board. One end of the output pin is connected to the surface of the side that is of the first metal layer and that is away from the first base, and the other end of the output pin penetrates the packaging housing and is configured to connect to the output of the circuit board. In addition, a first ground end and a second ground end are further disposed on the circuit board. The first ground end is connected to the input via two input capacitors connected in series, and the second ground end is connected to the output via two output capacitors connected in series. The at least one first pin includes two first pins. One end of one of the two first pins is electrically connected to the metal shield layer via the first opening and the second opening, and the other end of the first pin penetrates the packaging housing and is configured to connect to a connection point between the two input capacitors. One end of the other of the two first pins is electrically connected to the metal shield layer via the first opening and the second opening, and the other end of the other first pin penetrates the packaging housing and is configured to connect to a connection point between the two output capacitors. The power module of this structure may be the power module of the photovoltaic optimizer, the connection point between the two input capacitors is an input shield midpoint, and a connection point between the two output capacitors is an output shield midpoint. The metal shield layer can reduce electromagnetic interference generated by a plurality of power components and the first metal layer to another module of the power converter. In this technical solution, the first pin is a non-shield pin, and includes a power pin and/or a driver pin. The second pin is a shield pin.

When there are a plurality of second pins, the second pins may be all disposed on a same side edge, to facilitate manufacturing. In a technical solution, the at least one second pin may include two second pins, and the two second pins are respectively located at two ends of the first side edge.

The power module further includes a second metal layer, and the second metal layer is disposed on a surface of a side that is of the second base and that is away from the metal shield layer. A surface of a side of the packaging housing is provided with a third opening, and the second metal layer is exposed from the third opening. The second metal layer is configured to be attached to a heat sink to exchange heat with the heat sink. In this technical solution, the second metal layer may be used as a heat dissipation surface of the power module, and directly transfers heat inside the power module to the heat sink, to implement heat dissipation for the power module.

The first base and the second base may alternatively be disposed as two bases of an equal size. Specifically, the first base and the second base may be square bases. The first base further includes a fifth side edge and a sixth side edge that are oppositely disposed, and the second base includes a seventh side edge and an eighth side edge that are oppositely disposed. A distance between the fifth side edge and the sixth side edge is equal to a distance between the seventh side edge and the eighth side edge, projection of the fifth side edge on the second base is located on a same straight line as the seventh side edge, and projection of the sixth side edge on the second base is located on a same straight line as the eighth side edge. In other words, the projection of the four sides of the first base on the second base all coincide with the four sides of the second base. In this way, the tooling limiting member can limit the first base and the second base in any direction, to flexibly weld the first base and the second base.

According to a third aspect, this application provides a photovoltaic module. The photovoltaic module includes at least one photovoltaic panel and the power converter according to the first aspect. The power converter is disposed on the at least one photovoltaic panel, and is configured to output a direct current output by the at least one photovoltaic panel at maximum power. The power converter is used as a photovoltaic optimizer and is integrated with the photovoltaic panel. The power converter uses a double-layer DBC substrate structure, and in at least one direction, sizes of two DBC substrates are equal, and the two DBC substrates overlap, to facilitate welding of bases and avoid a safety risk caused by a welding deviation. In addition, the double-layer DBC substrate structure and a trace-free design between the first pin and the first metal layer can reduce parasitic inductance, to meet a derating requirement, improve reliability of the power converter, and ensure maximum power output stability of the photovoltaic panel.

According to a fourth aspect, this application provides a photovoltaic system. The photovoltaic system includes a photovoltaic module, the power converter according to the first aspect, and an inverter. The photovoltaic module, the power converter, and the inverter are sequentially connected. The power converter is configured to stabilize a maximum power output of the photovoltaic module, and improve energy yield of the photovoltaic system. The inverter is configured to convert a direct current output by the power converter into an alternating current. The power converter of the photovoltaic system has good reliability, and maximum power output stability of the photovoltaic module is ensured.

### BRIEF DESCRIPTION OF DRAWINGS

FIG. 1 is a diagram of an application scenario of a photovoltaic system according to an embodiment of this application;
FIG. 2 is a diagram of a structure of a power converter according to an embodiment of this application;
FIG. 3 is a schematic of a principle of a circuit of a power converter according to an embodiment of this application;
FIG. 4 is a diagram of a structure of a power module according to an embodiment of this application;
FIG. 5 is a diagram of another structure of a power module according to an embodiment of this application;
FIG. 6 is a diagram of a structure of an upper-layer DBC substrate according to an embodiment of this application;
FIG. 7 is a diagram of a structure of a lower-layer DBC substrate according to an embodiment of this application;
FIG. 8 is a diagram of another structure of a power module according to an embodiment of this application;
FIG. 9 is a diagram of another structure of a power module according to an embodiment of this application;
FIG. 10 is a diagram of another structure of a power module according to an embodiment of this application;
FIG. 11 is a diagram of another structure of a power module according to an embodiment of this application;
FIG. 12 is a diagram of another structure of a power module according to an embodiment of this application; and
FIG. 13 is a diagram of another structure of a power module according to an embodiment of this application.

### Reference numerals:

10: photovoltaic system; 11: photovoltaic module; 12: power converter;
13: inverter; 14: power grid; 15: energy storage device;
121: circuit board; 122: power module; 123: heat sink;
200: packaging housing; 201: first metal layer; 202: first base;
203: metal shield layer; 204: second base; 205: second metal layer;
206: first pin; 207: second pin; 208: first MOSFET;
209: second MOSFET; 210: bypass diode; 211: inductor;
202a: first side edge; 202b: second side edge; 202c: fifth side edge;
202d: sixth side edge; 204a: third side edge; 204b: fourth side edge;
204c: seventh side edge; 204d: eighth side edge; 2011: groove;
2021: notch; 2022: through hole; 2023: welding joint; and
2081: conductive sheet.

### DESCRIPTION OF EMBODIMENTS

To make the objectives, technical solutions, and advantages of this application clearer, the following further describes this application in detail with reference to the accompanying drawings.

It should be noted that terms used in the following embodiments are merely intended to describe specific embodiments, but are not intended to limit this application. The singular expression "one", "a/an", "said", "the foregoing", "the", and "this" as used in this specification and the appended claims of this application are also intended to include expressions like "one or more", unless otherwise specified in the context clearly.

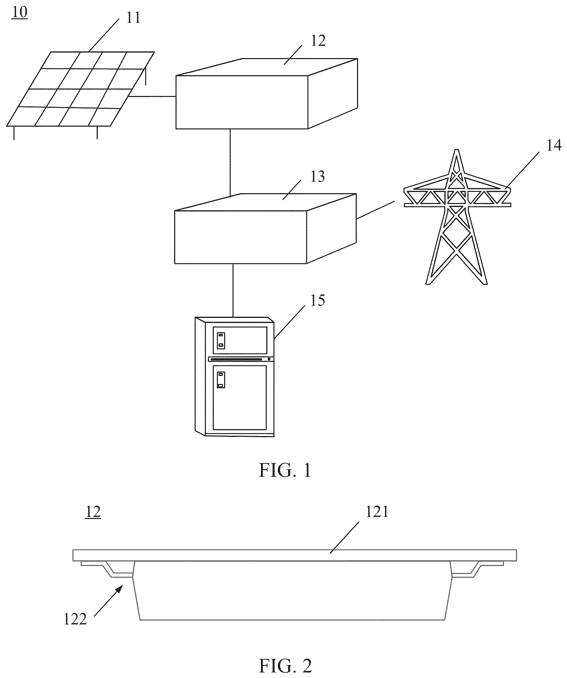

To facilitate understanding of a power module, a power converter, and a photovoltaic module provided in embodiments of this application, the following describes application scenarios of the power module, the power converter, and the photovoltaic module. The power converter in this application may be applied to a power supply system and a power generation system. The photovoltaic system is used as an example. The photovoltaic system may be used in application scenarios such as a home power plant and an industrial photovoltaic power plant. The photovoltaic system can convert solar energy into electric energy for a power grid or a load. FIG. 1 is a diagram of an application scenario of a photovoltaic system according to an embodiment of this application. As shown in FIG. 1, the photovoltaic system 10 is used in a home power plant. Specifically, the photovoltaic system 10 includes a photovoltaic module 11, a power converter 12, and an inverter 13 that are sequentially connected. The photovoltaic module 11 is configured to convert solar energy into electric energy. The power converter 12 may be used as an optimizer and connected to an output of the photovoltaic module 11. During actual application, energy yield of the photovoltaic module 11 is affected due to factors such as shadow shading, inconsistent orientations, or differences in electrical specifications of modules. Therefore, the optimizer can continuously perform MPPT on each photovoltaic module, to implement a maximum power output of the photovoltaic module 11, thereby improving energy yield of the photovoltaic system 10. One end of the inverter 13 is configured to connect to the power converter 12, and the other end is configured to connect to a load and/or a power grid 14. The inverter 13 is configured to: convert a direct current output by the power converter 12 into an alternating current, and transfer the alternating current to the power grid 14. Certainly, the photovoltaic system 10 may further include an energy storage device 15. The alternating current converted by the inverter 13 may be further transferred to the energy storage device 15 for energy storage.

In this embodiment of this application, the power converter 12 and the photovoltaic module 11 may be disposed independently of each other. Alternatively, the power converter 12 may be integrated with the photovoltaic module 11. For example, in an embodiment, the photovoltaic module 11 includes at least one photovoltaic panel and the power converter 12. The power converter 12 is disposed on the photovoltaic panel, and the power converter 12 is configured to output a direct current output by the at least one photovoltaic panel at maximum power.

FIG. 2 is a diagram of a structure of a power converter according to an embodiment of this application. As shown in FIG. 2, the power converter 12 includes a circuit board 121 and a power module 122. The power module 122 is located on one side of the circuit board 121, and the power module 122 is electrically connected to the circuit board 121.

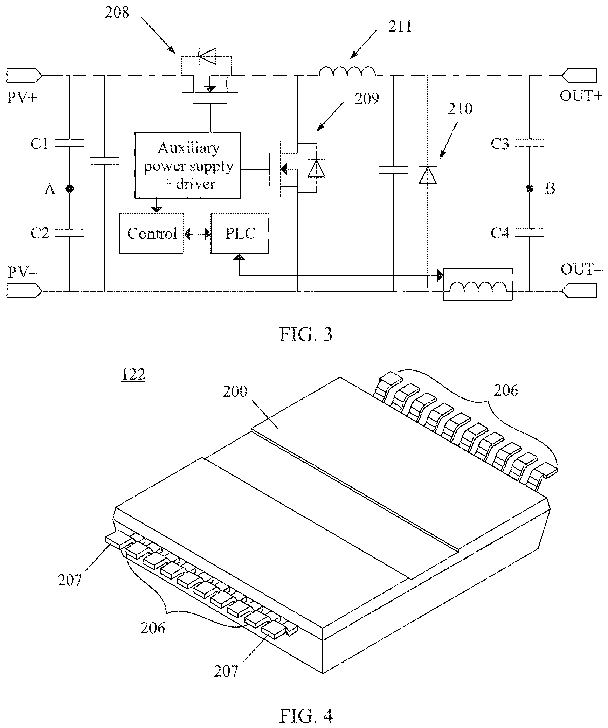

FIG. 3 is a schematic of a principle of a circuit of a power converter according to an embodiment of this application. As shown in FIG. 3, when the power converter 12 is used as an optimizer, the power converter 12 includes a power optimizing circuit. The power optimizing circuit may include a buck circuit, and power components of the buck circuit specifically include a first MOSFET 208, a second MOSFET 209, a bypass diode 210, and an inductor 211. The first MOSFET 208, the second MOSFET 209, and the bypass diode 210 are located in the power module 122, and the inductor 211 is disposed on the circuit board 121. The first MOSFET 208 and the second MOSFET 209 are connected in series to form a half-bridge structure, and the second MOSFET 209 and the bypass diode 210 are connected in parallel. The power module 122 uses a double-layer DBC substrate structure, and the first MOSFET 208, the second MOSFET 209, and the bypass diode 210 are disposed on the double-layer DBC substrate structure and are packaged.

A DBC substrate includes a ceramic base and two metal layers respectively disposed on surfaces of two sides of the ceramic base. In a current optimizer, a double-layer DBC substrate structure of a power module uses two DBC substrates of different sizes. A large-sized DBC substrate and a small-sized DBC substrate are stacked and welded, and a power component is disposed on a surface of the small-sized DBC substrate. Metal layers welded between a ceramic base of the large-sized DBC substrate and a ceramic base of the small-sized DBC substrate may be used as a shield layer. A metal layer on a side that is of the large-sized DBC substrate and that is away from the small-sized DBC substrate may be used as a heat dissipation surface to exchange heat with a heat sink. In the optimizer, at least one first pin is led out from a metal layer on a side that is of the small-sized DBC substrate and that is away from the large-sized DBC substrate. At least one first pin and at least one second pin are led out from a side that is of the shield layer and that extends from the small-sized DBC substrate. The at least one first pin is electrically connected, via a bonding wire, to the metal layer on the side that is of the small-sized DBC substrate and that is away from the large-sized DBC substrate, and the at least one second pin is directly connected to the shield layer.

When the power module is manufactured, the two DBC substrates are fastened through welding. However, during welding, because the sizes of the two DBC substrates are different, one tooling detent can limit only either of the DBC substrates. As a result, the two DBC substrates are prone to deviate during welding, a deviation occurs during packaging of the power module, and consequently, a creepage distance is shortened and a safety risk is easily caused.

In view of this, this application provides a power module, a power converter, and a photovoltaic module, to facilitate welding of two layers of bases of the power module, thereby avoiding a safety risk caused by a welding deviation of the two layers of bases.

Reference to "an embodiment", "some embodiments", or the like described in this specification means that one or more embodiments of this application include a specific feature, structure, or characteristic described with reference to embodiments. Therefore, statements such as "in an embodiment", "in some embodiments", "in some other embodiments", and "in other embodiments", that appear at different places in this specification do not necessarily mean referring to a same embodiment, instead, they mean "one or more but not all of embodiments", unless otherwise specifically emphasized. The terms "include", "contain", "have", and their variants all mean "include but are not limited to", unless otherwise specifically emphasized.

The terms "first", "second", and the like in this application are merely intended for a purpose of description, and shall not be understood as an indication or implication of relative importance or implicit indication of a quantity of indicated technical features. Therefore, a feature limited by "first" or "second" may explicitly or implicitly include one or more features. In the description of this application, unless otherwise stated, "a plurality of" means two or more than two.

In addition, in this specification, orientation terms such as "top", "bottom", "up", and "down" are defined relative to orientations of structures schematically placed in the accompanying drawings. It should be understood that these orientation terms are relative concepts used for relative description and clarification, and may correspondingly change based on changes in the orientations in which the structure are placed.

The power module 122 in this application has advantages of a short hot link, a simple structure, and low costs. In addition, a double-layer DBC substrate structure design and a pin layout can effectively facilitate welding of two layers of DBC substrates, to avoid a safety problem caused by a welding deviation of the two layers of DBC substrates. In addition, when a pin length is not changed, the power module 122 can effectively reduce parasitic inductance inside a circuit, and reduce voltage stress of the first MOSFET 208 and the second MOSFET 209 when the circuit is turned on or off, to meet a derating requirement, thereby improving applicability and reliability of the power module 122.

It should be noted that, the creepage distance refers to a charged region between two conductive parts measured along an insulation surface, where the charged region is a region in which in different use cases, insulation materials are charged because the insulation materials around the conductors are electrically polarized. The charged region is usually formulated based on safety requirements. In this embodiment of this application, the creepage distance is a distance between the first pin and a metal layer of a lower-layer DBC substrate along a surface of a packaging housing of the power module, and/or a distance between the second pin and the metal layer of the lower-layer DBC substrate along the surface of the packaging housing of the power module.

In addition, a MOSFET has rated operating conditions, that is, parameters such as a maximum current, voltage, and temperature that are specified in design and manufacturing processes of the MOSFET and that are allowed for the MOSFET. When these ratings are exceeded, the MOSFET may be faulty or damaged. Therefore, to ensure that the MOSFET can operate stably and reliably in actual operation, derating needs to be designed for the MOSFET. Derating manners include heat dissipation, current and voltage control, power reduction, and the like.

The following describes a structure of the power module 122 in this application in detail.

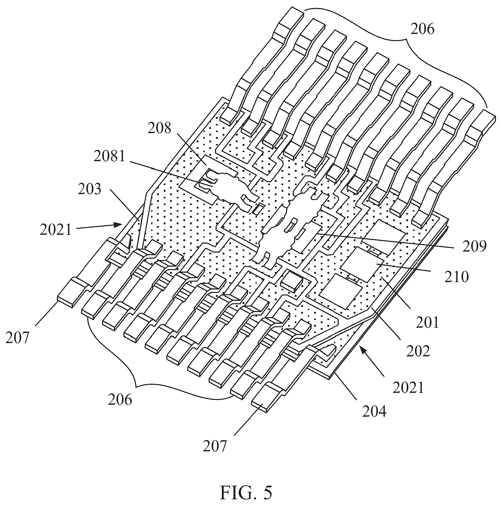

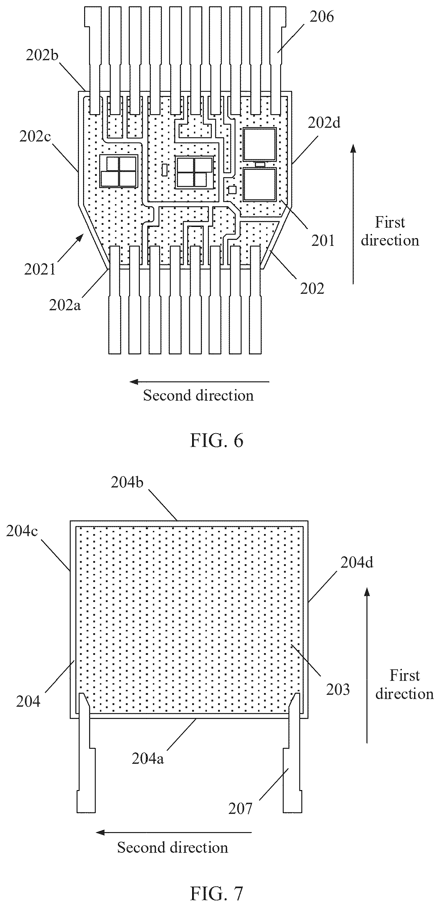

FIG. 4 is a diagram of a structure of a power module according to an embodiment of this application, and FIG. 5 is a diagram of another structure of a power module according to an embodiment of this application. As shown in FIG. 4 and FIG. 5, the power module 122 includes a packaging housing 200, a first metal layer 201, a first base 202, a metal shield layer 203, and a second base 204. The first metal layer 201, the first base 202, the metal shield layer 203, and the second base 204 are located in the packaging housing 200 and are sequentially stacked. FIG. 6 is a diagram of a structure of an upper-layer DBC substrate according to an embodiment of this application, and FIG. 7 is a diagram of a structure of a lower-layer DBC substrate according to an embodiment of this application. As shown in FIG. 6 and FIG. 7, in a direction perpendicular to the first base 202, the first base 202 includes a first side edge 202a and a second side edge 202b that are oppositely disposed, and the second base 204 includes a third side edge 204a and a fourth side edge 204b that are oppositely disposed. The power module 122 in this application uses a double-layer base structure. Specifically, the first base 202 and the second base 204 are fastened together through welding. A distance between the first side edge 202a and the second side edge 202b is equal to a distance between the third side edge 204a and the fourth side edge 204b, projection of the first side edge 202a on the second base 204 coincides with the third side edge 204a, and projection of the second side edge 202b on the second base 204 coincides with the fourth side edge 204b. It should be noted that, that projection that is of a side edge of a base and that is on another base coincides with a side edge of the another base means that the projection that is of the side edge of the base and that is on the another base is located on a same straight line as the side edge of the another base. In other words, projection of the first side edge 202a on the second base 204 is located on a same straight line as the third side edge 204a, and projection of the second side edge 202b on the second base 204 is located on a same straight line as the fourth side edge 204b. During welding, because the first base 202 and the second base 204 have equal sizes in a first direction (the first direction is a direction opposite to the first side edge 202a and the second side edge 202b, that is, a direction perpendicular to the first side edge 202a and the second side edge 202b), same tooling may be used to limit both the first base 202 and the second base 204 in the first direction, to facilitate welding of the two layers of bases of the power module 122, thereby avoiding a safety risk caused by a welding deviation of the two layers of bases. In this way, reliability of the power converter 12 can be improved, and maximum power output stability of the photovoltaic module 11 can be ensured.

Still refer to FIG. 6 and FIG. 7. A plurality of power components and a plurality of pins are disposed on a side that is of the first metal layer 201 and that is away from the first base 202, and the plurality of pins are disposed along the first side edge 202a and/or the second side edge 202b. The plurality of pins separately penetrate the packaging housing 200 and are configured to connect to the circuit board 121. The plurality of pins include at least one first pin 207 and at least one second pin 206. At least one of the first side edge 202a and the second side edge 202b is provided with a first opening, the first metal layer 201 is provided with a second opening disposed in correspondence with the first opening, and the first opening communicates with the second opening. One end of the at least one first pin 207 is electrically connected to the metal shield layer 203 via the second opening of the first metal layer 201 and the first opening of the second base 204, and the other end of the at least one first pin 207 penetrates the packaging housing 200 and is connected to the circuit board 121.

When the power converter 12 is used as a photovoltaic optimizer, the upper-layer DBC substrate includes the first metal layer 201, the first base 202, and a part that is of the metal shield layer 203 and that is in contact with the first base 202, and the lower-layer DBC substrate includes the second base 204 and a part that is of the metal shield layer 203 and that is in contact with the second base 204. The upper-layer DBC substrate is disposed close to the circuit board 121, and the lower-layer DBC substrate is located on a side that is of the upper-layer DBC substrate and that is away from the circuit board 121. The at least one first pin 207 may be used as a shield pin. One end of the first pin 207 is electrically connected to the metal shield layer 203 via the first opening and the second opening. In this way, the metal shield layer 203 may be used as a shield layer of the first metal layer 201 and the plurality of power components, to reduce electromagnetic interference generated by the power components and the first metal layer 201 to another module of the power converter 12, thereby improving electromagnetic compatibility of the power converter 12.

The at least one second pin 206 is a non-shield pin, and may include a power pin and/or a driver pin. Specifically, one end of the at least one second pin 206 is connected to a surface of a side that is of the first metal layer 201 and that is away from the first base 202, and the other end of the at least one second pin 206 penetrates the packaging housing 200 and is connected to the circuit board 121. The first metal layer 201 is directly connected to the second pin 206. In this way, a trace connection between the second pin 206 and the first metal layer 201 can be simplified, thereby reducing parasitic inductance, and suppressing voltage and current spikes and electromagnetic interference caused by the parasitic inductance, to improve circuit stability of the power module 122.

As shown in FIG. 5, locations and quantities of first openings and second openings may be specifically designed based on a layout of first pins 207. In an embodiment, the upper-layer DBC substrate is provided with two first openings and two second openings on a side of the first side edge 202a, that is, each of two ends of the first side edge 202a is respectively provided with one first opening, and the first metal layer 201 is correspondingly provided with the two second openings. One of the two second openings communicates with the first opening at one end of the first side edge 202a, and the other of the two second openings communicates with the first opening at the other end of the first side edge 202a. The plurality of pins include two first pins 207 disposed on the first side edge 202a. One end of one first pin 207 is connected, via the first opening at the one end of the first side edge 202a and a corresponding second opening, to a surface of a side that is of the metal shield layer 203 and that is away from the second base 204. One end of the other first pin 207 is connected, via the first opening at the other end of the first side edge 202a and a corresponding second opening, to the surface of the side that is of the metal shield layer 203 and that is away from the second base 204. In this way, on the same side edge of the first base 202, the two first openings can be directly provided and the two first pins 207 can be welded, to facilitate operation.

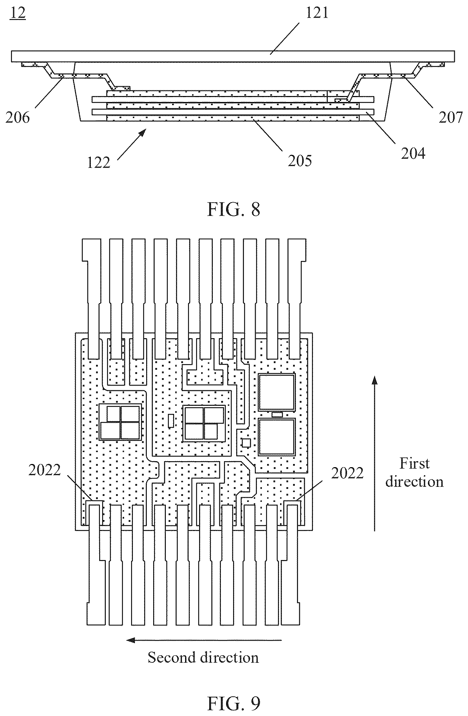

The first opening and the second opening may be specifically notches. FIG. 8 is a diagram of another structure of a power module according to an embodiment of this application. As shown in FIG. 5 and FIG. 8, the first metal layer 201 and the first base 202 are separately provided with a notch 2021, and the notch 2021 of the first metal layer 201 communicates with the notch 2021 of the first base 202. The one end of the first pin 207 may be disposed in the notch 2021, and directly connected to the surface of the side that is of the metal shield layer 203 and that is away from the second base 204, thereby implementing an electrical connection between the first pin 207 and the metal shield layer 203. The other end of the first pin 207 extends and penetrates the packaging housing 200. The one end of the first pin 206 is disposed on the surface of the side that is of the first metal layer 201 and that is away from the first base 202, the one end of the first pin 206 is directly electrically connected to the surface of the side that is of the first metal layer 201 and that is away from the first base 202, and the other end of the second pin 206 extends and penetrates the packaging housing 200.

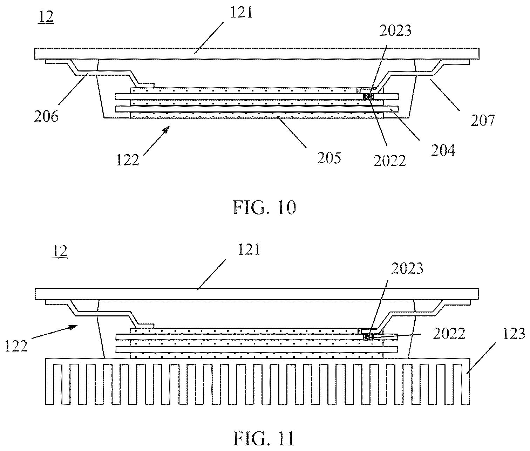

The first opening and the second opening may be specifically through holes. FIG. 9 is a diagram of another structure of a power module according to an embodiment of this application, FIG. 10 is a diagram of another structure of a power module according to an embodiment of this application, and FIG. 11 is a diagram of another structure of a power module according to an embodiment of this application. As shown in FIG. 9, FIG. 10, and FIG. 11, an upper-layer DBC substrate is provided with a through hole 2022. The through hole 2022 penetrates the first metal layer 201 and the first base 202. In other words, the first metal layer 201 and the first base 202 are separately provided with the through hole 2022, and the through hole 2022 of the first metal layer 201 communicates with the through hole 2022 of the first base 202. The power module 122 may further include a welding joint 2023. The welding joint 2023 is located in the through hole 2022 of the first base 202, and the welding joint 2023 is used to weld the at least one first pin 207 to the metal shield layer 203. The one end of the at least one first pin 207 is located on a surface of a side that is of the first base 202 and that is away from the metal shield layer 203, the one end is welded to one end of the welding joint 2023, and the other end of the welding joint 2023 is welded to the metal shield layer 203.

The power converter 12 may be the photovoltaic optimizer. As shown in FIG. 3, specifically, the power optimization circuit includes an input (PV+), a driver chip, an output (OUT+), a first ground end (PV-), and a second ground end (OUT-). The input (PV+), the driver chip, the output (OUT+), the first ground end (PV-), and the second ground end (OUT-) are separately disposed on the circuit board 121. The first ground end (PV-) is connected to the input (PV+) via two input capacitors (C1 and C2) connected in series, and the second ground end (OUT-) is connected to the output (OUT+) via two output capacitors (C3 and C4) connected in series. A connection point between the two input capacitors (C1 and C2) is an input shield midpoint A, and a connection point between the two output capacitors (C3 and C4) is an output shield midpoint B. The at least one first pin 207 includes the two first pins 207. The one end of the one of the two first pins 207 is connected to the metal shield layer 203, and the other end of the one of the first pins 207 penetrates the packaging housing 200 and is configured to connect to the input shield midpoint A. The one end of the other of the two first pins 207 is connected to the metal shield layer 203, and the other end of the other first pin 207 penetrates the packaging housing 200 and is configured to connect to the output shield midpoint B.

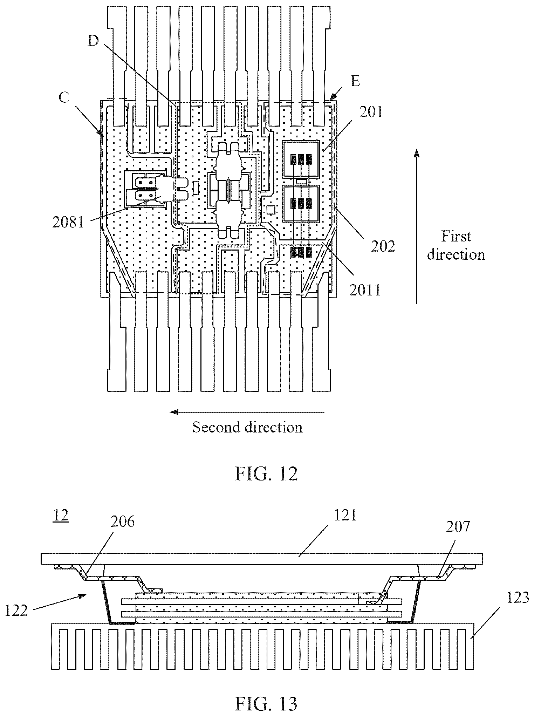

FIG. 12 is a diagram of another structure of a power module according to an embodiment of this application. As shown in FIG. 12, during actual application, based on a specific design of the power optimization circuit, a plurality of grooves 2011 are disposed at the first metal layer 201, the plurality of grooves 2011 divide the first metal layer 201 into a plurality of line regions, and the plurality of line regions include a first line region C, a second line region D, and a third line region E. The first MOSFET 208, the second MOSFET 209, and the bypass diode 210 are disposed on the surface of the side that is of the first metal layer 201 and that is away from the first base 202, and the first MOSFET 208, the second MOSFET 209, and the bypass diode 210 are sequentially arranged in an extension direction of the first side edge 202a. In this way, a trace layout can be optimized, to avoid trace crossing or winding, thereby shortening a circuit loop of the power module 122, and reducing interference of a trace to the circuit. The first MOSFET 208 is located in the first line region C, the second MOSFET 209 is located in the second line region D, and the bypass diode 210 is located in the third line region E. In the buck circuit, the first MOSFET 208 and the second MOSFET 209 are connected in series to form a half-bridge structure, and the bypass diode 210 is connected in parallel to the second MOSFET 209. Specifically, the power module 122 further includes a conductive part, and the conductive part may be a conductive sheet or a bonding wire. In FIG. 12, a conductive sheet 2081 is used as an example for description. One end of the conductive sheet 2081 is connected to the first MOSFET 208, and the other end of the conductive sheet 2081 is connected to the second MOSFET 209, to connect the first MOSFET 208 and the second MOSFET 209 in series. The other end of the at least one second pin 206 penetrates the packaging housing 200 and is connected to the circuit board 121, and the second MOSFET 209 is connected in parallel to the bypass diode 210 via the at least one second pin 206 and a metal trace of the circuit board 121. When the power converter 12 operates, electromagnetic wave interference is generated in the first MOSFET 208, the second MOSFET 209, the conductive sheet 2081, and the second line region D in which the second MOSFET 209 is located, and the metal shield layer 203 between the first base 202 and the second base 204 can implement an electromagnetic wave shield function, thereby improving the electromagnetic compatibility of the power converter 12.

The second pin 206 is the non-shield pin, and includes the power pin and the driver pin. One end of the power pin is configured to connect to a drain D of a MOSFET, and one end of the driver pin is configured to connect to a gate G and a source S of the MOSFET. The at least one second pin 206 may further include an input pin. One end of the input pin is connected to the surface of the side that is of the first metal layer 201 and that is away from the first base 202, and the other end of the input pin penetrates the packaging housing 200 and is connected to the input (PV+) of the circuit board 121. One end of the driver pin is connected to the surface of the side that is of the first metal layer 201 and that is away from the first base 202, and the other end of the driver pin penetrates the packaging housing 200 and is connected to the driver chip of the circuit board 121. One end of the output pin is connected to the surface of the side that is of the first metal layer 201 and that is away from the first base 202, and the other end of the output pin penetrates the packaging housing 200 and is connected to the output (OUT+) of the circuit board 121.

In some other application scenarios, there may alternatively be one first pin 207. The first pin 207 may be grounded, so that a shield function of the metal shield layer 203 can also be implemented.

As shown in FIG. 8 and FIG. 10, in the foregoing optimizer scenario, the power module 122 may further include a second metal layer 205, and the second metal layer 205 is disposed on a surface of a side that is of the second base 204 and that is away from the metal shield layer 203. In other words, the lower-layer DBC substrate includes the part that is of the metal shield layer 203 and that is in contact with the second base 204, the second base 204, and the second metal layer 205. In addition, a surface of a side that is of the packaging housing 200 and that faces the second metal layer 205 is provided with a third opening, and the second metal layer 205 is exposed from the third opening. In this way, when the power module 122 is packaged, because the first base 202 is aligned with the second base 204, the welding deviation can be avoided for the two layers of welded DBC substrates.

FIG. 13 is a diagram of another structure of a power module according to an embodiment of this application. As shown in FIG. 13, the power converter 12 further includes a heat sink 123. The heat sink 123 is attached to the second metal layer 205 to exchange heat with the second metal layer 205, to directly transfer heat of the power module 122 to the heat sink 123, and implement heat dissipation for the power module 122. After packaging, the second metal layer 205 is exposed from the third opening of the packaging housing 200, so that creepage distances (as shown by bold solid lines in FIG. 13), along a surface of the packaging housing 200, between a surface of the heat sink 123, and the second pin 206 and the first pin 207 meets a safety requirement.

As shown in FIG. 9 and FIG. 12, the first base 202 and the second base 204 have equal sizes in the first direction, and may also have equal sizes in a second direction. The first direction is perpendicular to the second direction. Specifically, the first base 202 and the second base 204 may be square bases. The first base 202 further includes a fifth side edge 202c and a sixth side edge 202d that are oppositely disposed, and the second base 204 includes a seventh side edge 204c and an eighth side edge 204d that are oppositely disposed. A distance between the fifth side edge 202c and the sixth side edge 202d is equal to a distance between the seventh side edge 204c and the eighth side edge 204d, projection of the fifth side edge 202c on the second base 204 is located on a same straight line as the seventh side edge 204c, and projection of the sixth side edge 202d on the second base 204 is located on a same straight line as the eighth side edge 204d. In other words, the projection of the four sides of the first base 202 on the second base 204 all coincide with the four sides of the second base 204. In this way, the tooling limiting member can limit the first base 202 and the second base 204 in the first direction or the second direction (the second direction is a direction opposite to the fifth side edge 202c and the sixth side edge 202d, that is, a direction perpendicular to the fifth side edge 202c and the sixth side edge 202d), to flexibly dispose the first base 202 and the second base 204.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power converter, comprising a circuit board and a power module, wherein the power module is located on one side of the circuit board, wherein
the power module comprises a packaging housing, and a first metal layer, a first base, a metal shield layer, and a second base that are located in the packaging housing and that are sequentially stacked, wherein the first base comprises a first side edge and a second side edge that are oppositely disposed, the second base comprises a third side edge and a fourth side edge that are oppositely disposed, a distance between the first side edge and the second side edge is equal to a distance between the third side edge and the fourth side edge, projection of the first side edge on the second base is located on a same straight line as the third side edge, projection of the second side edge on the second base is located on a same straight line as the fourth side edge, at least one of the first side edge and the second side edge is provided with a first opening, the first metal layer is provided with a second opening disposed in correspondence with the first opening, and the first opening communicates with the second opening; and
the power module further comprises at least one first pin, one end of the at least one first pin is electrically connected to the metal shield layer via the second opening of the first metal layer and the first opening of the first base, and the other end of the at least one first pin penetrates the packaging housing and is connected to the circuit board.

2. The power converter according to claim 1, wherein the first opening and the second opening are notches, and the one end of the at least one first pin is connected, via the notch of the first metal layer and the notch of the first base, to a surface of a side that is of the metal shield layer and that is away from the second base.

3. The power converter according to claim 1, wherein the first opening and the second opening are through holes, and a welding joint is disposed in the through hole of the first base; the one end of the at least one first pin is located on a surface of a side that is of the first base and that is away from the metal shield layer, and is welded to one end of the welding joint; and the metal shield layer is welded to the other end of the welding joint.

4. The power converter according to any one of claims 1 to 3, wherein the power module further comprises at least one second pin, one end of the at least one second pin is connected to a surface of a side that is of the first metal layer and that is away from the first base, and the other end of the at least one second pin penetrates the packaging housing and is connected to the circuit board.

5. The power converter according to claim 4, wherein a plurality of grooves are disposed at the first metal layer, the plurality of grooves divide the first metal layer into a plurality of line regions, and the plurality of line regions comprise a first line region, a second line region, and a third line region;
the power module further comprises a first metal-oxide-semiconductor field-effect transistor, a second metal-oxide-semiconductor field-effect transistor, and a bypass diode, wherein the first metal-oxide-semiconductor field-effect transistor, the second metal-oxide-semiconductor field-effect transistor, and the bypass diode are disposed on the surface of the side that is of the first metal layer and that is away from the first base, the first metal-oxide-semiconductor field-effect transistor, the second metal-oxide-semiconductor field-effect transistor, and the bypass diode are sequentially arranged in an extension direction of the first side edge, the first metal-oxide-semiconductor field-effect transistor is located in the first line region, the second metal-oxide-semiconductor field-effect transistor is located in the second line region, and the bypass diode is located in the third line region;
the power module further comprises a conductive sheet or a bonding wire, wherein one end of the conductive sheet or the bonding wire is connected to the first metal-oxide-semiconductor field-effect transistor, and the other end of the conductive sheet or the bonding wire is connected to the second metal-oxide-semiconductor field-effect transistor, to connect the first metal-oxide-semiconductor field-effect transistor and the second metal-oxide-semiconductor field-effect transistor in series; and
the second metal-oxide-semiconductor field-effect transistor is connected in parallel to the bypass diode via the at least one second pin and a metal trace of the circuit board.

6. The power converter according to claim 4 or 5, wherein an input, a driver chip, and an output are disposed on the circuit board, the at least one second pin comprises an input pin, a driver pin, and an output pin, one end of the input pin is connected to the surface of the side that is of the first metal layer and that is away from the first base, the other end of the input pin penetrates the packaging housing and is connected to the input, one end of the driver pin is connected to the surface of the side that is of the first metal layer and that is away from the first base, the other end of the driver pin penetrates the packaging housing and is connected to the driver chip, one end of the output pin is connected to the surface of the side that is of the first metal layer and that is away from the first base, and the other end of the output pin penetrates the packaging housing and is connected to the output; and
a first ground end and a second ground end are further disposed on the circuit board, the first ground end is connected to the input via two input capacitors connected in series, the second ground end is connected to the output via two output capacitors connected in series, the at least one first pin comprises two first pins, a connection point between the two input capacitors is connected to one of the two first pins, and a connection point between the two output capacitors is connected to the other one of the two first pins.

7. The power converter according to any one of claims 1 to 6, wherein the at least one first pin comprises the two first pins, and the two first pins are respectively located at two ends of the first side edge.

8. The power converter according to any one of claims 1 to 7, wherein the power module further comprises a second metal layer, and the second metal layer is disposed on a surface of a side that is of the second base and that is away from the metal shield layer;
a surface of a side that is of the packaging housing and that is away from the circuit board is provided with a third opening, and the second metal layer is exposed from the third opening; and
the power converter further comprises a heat sink, wherein the heat sink is attached to the second metal layer to exchange heat with the second metal layer.

9. The power converter according to any one of claims 1 to 8, wherein the first base further comprises a fifth side edge and a sixth side edge that are oppositely disposed, the second base comprises a seventh side edge and an eighth side edge that are oppositely disposed, a distance between the fifth side edge and the sixth side edge is equal to a distance between the seventh side edge and the eighth side edge, projection of the fifth side edge on the second base is located on a same straight line as the seventh side edge, and projection of the sixth side edge on the second base is located on a same straight line as the eighth side edge.

10. A power module, comprising a packaging housing, and a first metal layer, a first base, a metal shield layer, and a second base that are located in the packaging housing and that are sequentially stacked, wherein
the first base comprises a first side edge and a second side edge that are oppositely disposed, the second base comprises a third side edge and a fourth side edge that are oppositely disposed, a distance between the first side edge and the second side edge is equal to a distance between the third side edge and the fourth side edge, projection of the first side edge on the second base is located on a same straight line as the third side edge, projection of the second side edge on the second base is located on a same straight line as the fourth side edge, at least one of the first side edge and the second side edge is provided with a first opening, the first metal layer is provided with a second opening disposed in correspondence with the first opening, and the first opening communicates with the second opening; and
the power module further comprises at least one first pin, one end of the at least one first pin is electrically connected to the metal shield layer via the second opening of the first metal layer and the first opening of the first base, and the other end of the at least one first pin penetrates the packaging housing.

11. A photovoltaic module, comprising at least one photovoltaic panel and the power converter according to any one of claims 1 to 9, wherein the power converter is disposed on the at least one photovoltaic panel, and is configured to output a direct current output by the at least one photovoltaic panel at maximum power.
